# EUROPEAN PATENT APPLICATION

(11) **EP 2 072 464 A1**
(43) Date of publication of application: **24.06.2009**
(21) Application number: 07828444.5
(22) Date of filing: 26.09.2007
(51) Int. Cl.: C01B 33/037

(54) **METHOD FOR PURIFICATION OF SILICON, SILICON, AND SOLAR CELL**

(30) Priority: 29.09.2006 JP 2006268631
(71) Applicant: Shin-Etsu Chemical Co., Ltd., Tokyo 100-0004 (JP)
(72) Inventor: YAMADA, Motoyuki, Annaka-shi Gunma 379-0195 (JP); HATAYAMA, Kazuhisa, Annaka-shi Gunma 379-0195 (JP)
(74) Representative: Michalski Hüttermann & Partner Patentanwälte
(86) International application number: PCT/JP2007/068698
(87) International publication number: WO 2008/035799

(57) **Abstract**

The present invention provides a silicon purifying method for purifying silicon metal to manufacture solar cell silicon by reducing boron contained as impurities in the silicon metal. The present invention provides a silicon purifying method including preparing a mixture containing both silicon in a molten state and a molten salt, introducing a gas containing a chlorine atom into the mixture, and introducing moisture vapor together with the chlorine-atom containing gas. The chlorine-atom containing gas may preferably be a chlorine gas or silicon tetrachloride. The molten salt may preferably be composed of a mixture containing at least silicon dioxide and calcium oxide, and the mixture may additionally contain calcium fluoride.

## Description

### TECHNICAL FIELD

The present invention relates to a method of increasing the purity of, i.e., purifying industrially manufactured silicon. More specifically, the present invention relates to a method of purifying silicon to be favorably used for solar cells. The present application relates to the following Japanese patent application. The contents of the patent application identified below are incorporated by reference herein, if applicable.
1. Japanese Patent Application No. 2006-268631 filed on September 29, 2006

### BACKGROUND ART

Fossil energy emits carbonic acid gas and thus contributes to global warming. Therefore, a variety of types of alternative energies have been proposed and put into practical use. Among such alternative energies, photovoltaic power generation have been increasingly utilized over the years for many reasons including a wide distribution of solar energy on the earth, possibility of relatively small-sized equipment, and a long history of practical use.

Among diverse photovoltaic power generation methods, solar cells is the most common method, which uses silicon wafers to form battery cells. The impurity concentration of silicon used for solar cell silicon wafers (hereinafter referred to as solar-cell silicon) does not have to be as low as the impurity concentration of silicon used for semiconductors (hereinafter referred to as semiconductor silicon). Specifically speaking, in the case of the semiconductor silicon, the impurity concentration is desirably reduced to as low a level as possible and the necessary purity is thus 99.99999999% (10N). In the case of the solar cell silicon, on the other hand, the necessary purity is 99.999 % (5N) to 99.9999 % (6N).

Conventional raw materials for solar cell silicon having such an impurity concentration include, in addition to semiconductor silicon with a purity of 99.999999999% (10N), silicon obtained by reprocessing or purifying off-grade silicon, to be specific, silicon that is discarded during the manufacturing process of semiconductor silicon due to condensation of impurities and attachment of foreign substances. Thus, the raw materials of the solar cell silicon are the semiconductor silicon or its derivatives. For this reason, the supply of the raw materials of the solar cell silicon is influenced by the rise and fall of the semiconductor industry, and often falls short ofthe demand for the solar cell silicon.

To address this issue, researches and studies have been conducted to enhance the purity of silicon metal, which offers sufficient industrial production and use the silicon metal as the solar cell silicon. The main impurities in silicon metal include metal elements such as iron, aluminum, calcium, and titanium, and non-metal elements such as boron and phosphors, which act as dopants. Here, the metal elements have a very low solidification partition coefficient with respect to silicon. For example, the solidification partition coefficient of iron, which usually occupies the largest portion of the impurity components in silicon metal, is only 8×10⁻⁶. Accordingly, the iron concentration within solid silicon is low at the start of solidification, and gradually increases from the middle stage to the final stage of the solidification. Based on this solidification segregation, silicon with a low iron concentration can be obtained by selecting a portion with a desired iron concentration from the ingot. In a similar manner, silicon with a low concentration ofthe other impurity metal elements can be also obtained.

Here, boron acts as dopants in silicon and its concentration in solar cell silicon therefore needs to be controlled. Nevertheless, the solidification partition coefficient of boron is close to 1, specifically, 0.8, and boron is thus hardly segregated by the above solidification segregation. Therefore, various methods have been developed to eliminate boron using techniques other than the solidification segregation.

For example, Patent Document 1 discloses a silicon purifying method in which silicon containing impurity elements such as boron (B), carbon (C), phosphor (P), iron (Fe), and aluminum (Al) melts within a container that has a gas inlet at its bottom and is mainly made of silica, and argon (Ar), helium (He) or a combination thereof is blown into the container through the gas inlet.

Patent Document 2 discloses a method for effectively eliminating boron contained as impurities in silicon used for solar cells and the like during the manufacturing process ofthe silicon. According to this silicon purifying method, silicon is kept molten within a container having a gas inlet at its bottom, and a gas mixture containing no more than 1 volume % of N₂ and one of Ar, H₂ and a combination thereof is blown into the container through the gas inlet.

Patent Document 3 teaches that impurities can be efficiently eliminated by supplying at least one type of gas selected from inert gas, moisture vapor, and carbon monoxide into a melt containing a mixture of silicon dioxide (SiO₂) and calcium oxide (CaO) and molten silicon.

Patent Document 4 discloses a method of manufacturing silicon with an intermediate purity. This method includes refining silicon with a low content of boron based on carbothermal reduction of silica in a submerged-arc electric furnace, refining liquid silicon by using oxygen or chlorine, injecting a neutral gas and processing the refined silicon under a reduced pressure of 10 Pa to 100 Pa, and effecting separation solidification.

Patent Document 5 discloses a method of refining silicon used for manufacturing, in particular, solar cells. This method includes re-melting refined silicon under a neutral atmosphere within an electric furnace provided with a high-temperature crucible, transferring the molten silicon to an electric furnace provided with a high-temperature crucible in order to refine the molten silicon under plasma, refining the molten silicon under plasma by using a mixture of argon and at least one gas selected from a group consisting of chlorine, fluorine, hydrogen chloride (HCl), and hydrogen fluoride (HF) as a plasma generation gas, and casting the silicon into a casting mold, in which separation solidification is realized, under a controlled atmosphere.

Patent Document 6 discloses a silicon purifying method, in which silicon containing impurities is generated by heating a mixture of carbon (C) and silica and thus liberating carbon dioxide and forming a silicon melting bath, and the silicon is refined by bubbling a gas mixture of chlorine and oxygen in the molten silicon of the generated impurity-containing silicon. Patent Document 7 discloses a high-purity silicon metal manufacturing method characterized by blowing a gas mixture containing moisture vapor, hydrogen, and an inert gas into molten silicon.

Non-Patent Document 1 discusses whether titanium and iron are eliminated from silicon by using a technique of chlorinating titanium and iron by using chlorine. This document concludes that chlorination is of little effectiveness in eliminating iron and titanium.

Patent Document 1: Japanese Patent Application Publication No. 04-193706
Patent Document 2: Japanese Patent Application Publication No. 05-330815
Patent Document 3: Japanese Patent Application Publication No. 2003-238138
Patent Document 4: Japanese Patent Application Publication No. 2004-535354
Patent Document 5: Japanese Patent Application Publication No. 2004-537491
Patent Document 6: Japanese Patent Application Publication No. 55-010500
Patent Document 7: Japanese Patent Application Publication No. 2000-302434
Non-Patent Document 1: Joint Research Report "Development of Silicon Manufacturing Process for Rationalization of Energy Use" (Researches and Studies on Analysis for Practical Use of Solar Cell Silicon Raw Material Manufacturing Technique), New Energy and Industrial Technology Development Organization, 2000, pp. 121-123

### DISCLOSURE OF THE INVENTION

### PROBLEMS TO BE SOLVED BY THE INVENTION

The present invention aims to provide a silicon purifying method for purifying silicon metal to manufacture solar cell silicon by reducing boron contained as impurities in the silicon metal.

### MEANS FOR SOLVING THE PROBLEMS

To solve the above-described problems, a first embodiment of the present invention provides a silicon purifying method including preparing a mixture containing both silicon in a molten state and a molten salt, introducing a gas containing a chlorine atom into the mixture, and introducing moisture vapor together with the chlorine-atom containing gas.

The chlorine-atom containing gas may be a chlorine gas. The chlorine-atom containing gas may be silicon tetrachloride. Moisture vapor may be introduced together with the chlorine-atom containing gas. The molten salt may at least contain a mixture of silicon dioxide and calcium oxide. The molten salt may contain calcium fluoride. A weight ratio of the silicon dioxide in the molten salt may be 35 to 75 weight%. A weight ratio of the calcium fluoride in the molten salt is 1 to 20 weight%.

The silicon purifying method relating to the first embodiment may further include putting the molten salt into the silicon in the molten state during the preparation of the mixture. The preparation of the mixture may include heating and melting silicon by using an induction-heating electric furnace. The silicon purifying method may further include eliminating a metal element based on solidification segregation. The silicon purifying method may further include separating the silicon from the mixture containing both the silicon in the molten state and the molten salt after the silicon is purified. The preparation of the mixture may further include washing the silicon with an acid before the silicon turns into the molten state.

A ratio of the chlorine-atom containing gas and the moisture vapor may be substantially 1:3.

A second embodiment of the present invention provides silicon manufactured by using the silicon purifying method as set forth in one of Claims 1 to 13, wherein a boron concentration is equal to or less than 4 ppm. The boron concentration may be equal to or less than 1 ppm. The boron concentration may fall in a range from 0.1 ppm to 0.3 ppm.

A second embodiment of the present invention provides a solar cell manufactured by using, as a raw material, silicon manufactured by using the silicon purifying method relating to the first embodiment.

Here, all the necessary features of the present invention are not listed in the summary. The sub-combinations of the features may become the invention.

### EFFECT OF THE INVENTION

A silicon purifying method relating to an embodiment of the present invention can eliminate boron contained within silicon at a lower cost and more efficiently than any known silicon purifying methods.

### BRIEF DESCRIPTION OF THE DRAWINGS

Fig. 1 is a flow chart illustrating exemplary steps of a silicon purifying method relating to an embodiment ofthe present invention.
Fig. 2 is a schematic view illustrating an exemplary purifying apparatus 100 used in a silicon purifying method relating to an embodiment of the present invention.

### DESCRIPTION OF REFERENCE NUMERALS

100···purifying apparatus, 120···chamber, 140···core tube, 160···heat generator, 180···heat insulator, 142···flange, 200···crucible, 300···stage, 146···bubbling nozzle, 148···emission nozzle

### BEST MODE FOR CARRYING OUT THE INVENTION

Hereinafter, some embodiments of the present invention will be described. The embodiments do not limit the invention according to the claims, and all the combinations of the features described in the embodiments are not necessarily essential to means provided by aspects of the invention.

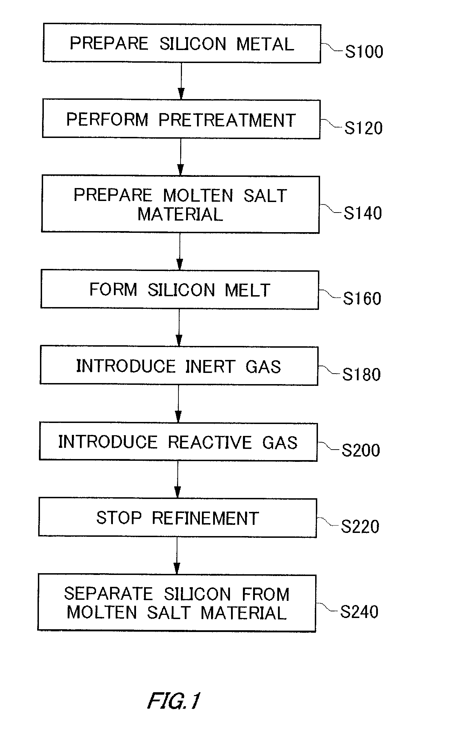

A purifying method relating to an embodiment of the present invention is characterized by introducing a gas containing an chlorine atom into a mixture containing both silicon metal in a molten state and a molten salt (a flux). The purifying method relating to the embodiment will be subsequently described in detail with reference to a flow chart of Fig. 1 showing the steps of the purifying method.

The steps of the purifying method relating to the embodiment of the present invention are described in the order performed. To begin with, silicon metal, which is to be purified, is prepared (a step S 100). Silicon metal normally contains impurities including metal elements such as iron, aluminum and calcium and non-metal elements such as boron and phosphors, which act as dopants in silicon.

Subsequently, the prepared silicon metal is subjected to particular pretreatment, so that the metal and non-metal components are reduced in advance (a step S120). This pretreatment may be, for example, impurity elimination based on solidification segregation. Alternatively, the pretreatment may be washing of the silicon metal with the use of an acid (acid leaching). Note that the pretreatment in the step S120 may not be essential in the purifying method relating to the embodiment of the present invention and that the silicon metal containing the impurities may be refined in subsequent steps. In a case where the silicon metal containing the impurities is refined without reduction in the impurities, the boron concentration may be first reduced by using the purifying method relating to the embodiment and the impurities may be then eliminated by using the solidification segregation.

After this, a molten salt material is prepared (a step S140). The molten salt may be composed of, for example, metal oxide, chloride, fluoride or a combination thereof The molten salt is required to satisfy the following characteristics requirements: (i) to remain molten at the melting temperature of the silicon metal, and (ii) to have a low vapor pressure at the melting processing temperature so as to be hard to evaporate or to decompose. Therefore, it is preferable to use an oxide-based molten salt, which has a low vapor pressure and is hard to thermally decompose.

Exemplary oxide-based molten salts include silicon dioxide (SiO₂) calcium oxide (CaO), magnesium oxide (MgO), sodium oxide (Na₂O), aluminum oxide (Al₂O₃), and a combination thereof Among these, a mixture of SiO₂ and CaO is preferred since its eutectic temperature is approximately 1,450 °C, which is substantially equal to the melting point of silicon. As an oxide-based molten salt, an oxide may be used, or a carbonate that becomes an oxide after heated, for example, CaCO₃ may be used and heated. A carbonate such as CaCO₃ decomposes after heated, to result in an oxide. Thus, a carbonate such as CaCO₃ can produce substantially the same effects as when an oxide is used.

When the molten salt has a single component, no blending is necessary. When the molten salt contains a plurality of components, on the other hand, it is preferable to blend the molten salt components in advance in order to obtain a molten salt with a predetermined composition and then to perform a silicon melting step with the resulting molten salt. Alternatively, a molten salt whose composition changes into the predetermined composition during the silicon melting step may be provided. According to the embodiment of the present invention, a molten salt that is principally composed of SiO₂ and CaO is favorably used because of its excellent vapor pressure and thermal-decomposition resistance as mentioned above. A favorable composition of this molten salt is such that the ratio by weight of the silicon dioxide falls within a range of 35 to 75 weight%, within which two eutectic points of SiO₂ and CaO are included. When the molten salt contains CaF, this weight percentage of silicon dioxide denotes the ratio of SiO₂ with respect to CaO, excluding CaF.

Alternatively, a molten salt containing calcium fluoride (CaF) can be favorably used since CaF can reduce the viscosity of the molten salt even when added in a small amount and at least does not have adverse influence on boron-eliminating effects. When CaF is added to a eutectic molten salt principally composed of SiO₂ and CaO, the blending ratio of CaF preferably falls within a range of 1 to 20 parts by weight (1 to 20 weight%), where the total of SiO₂, CaO and CaO is represented as 100 parts by weight, more preferably, within a range of 8 to 15 parts by weight.

Subsequently, the silicon metal and the prepared molten salt are placed in a crucible to obtain a mixture containing both molten silicon metal and a molten salt (hereinafter referred to as a silicon melt) (a step S160). Other methods to obtain the silicon melt may include putting the molten salt into the crucible while the furnace is heated, or putting the molten salt into the crucible after the silicon melts. The crucible is made of a material selected from materials that can resist a temperature equal to or higher than the temperature at which the silicon melts, for example, graphite, ceramic, silica glass and the like. When a container made of graphite is used, the atmosphere in which the container is placed needs to be non-oxidizing because of the oxidation nature of the container. When a container made of ceramic is used, the material and structure of the container need to be selected such that the container does not break from heat shock that occurs when the container is heated for the melting purpose. Furthermore, it is also necessary to consider whether any reaction is created between the crucible and the molten salt that melts concurrently with the silicon and melting ofthe crucible.

After this, a furnace in which the crucible having therein the silicon metal and the molten salt material is housed is heated so that the temperature increases. The furnace can be heated by using method such as resistance heating, induction heating and arc heating. The embodiment of the present invention can use any heating means. To industrially refine a large amount of silicon, it is preferable to use an induction heating electric furnace. According to the present embodiment, the silicon melts by heating of the furnace. Alternatively, however, the silicon may be melted in advance by a different unit and, while kept in the molten state, transferred to the refinement crucible used in the method relating to the embodiment of the present invention. As a further alternative, on completion of a silicon metal manufacturing process, molten silicon may be directly transferred from a silicon metal manufacturing furnace to the refinement crucible.

When the electric furnace reaches a predetermined temperature, the silicon and molten salt put in the crucible melt. Here, the phase change from a solid state to a liquid state of the silicon is clearly observed at a temperature near 1,450 °C, which is the melting point of the silicon. On the other hand, the molten salt does not have a clear melting point and is characterized in that its viscosity continuously decreases in accordance with the temperature rise. Therefore, it is preferable to consider the difference in viscosity between the molten silicon and the molten salt, in relation to contact between a reactive gas and the molten salt. Depending on the composition of the molten salt, some molten salt components may remain in the solid state even at the predetermined temperature. However, the viscosity of the molten salt and the existence of the solid-phase components do not influence the nature of the method relating to the embodiment of the present invention.

The boron in the silicon metal may be taken up by the molten salt. Therefore, the molten salt may be added to the molten silicon and then melted, so that the boron concentration decreases. The boron concentration reduction achieved in such a manner that the boron in the silicon metal is taken up by the molten salt cannot reduce the boron concentration to be equal to or lower than the concentration that is uniquely determined by the partition coefficient between the silicon and the molten salt. Therefore, a sufficient decrease in the boron concentration can be realized by increasing the amount of the molten salt in contact with the molten silicon. This method, however, is not realistic.

For this reason, the embodiment ofthe present invention uses a reactive gas in addition to the molten salt. Japanese Patent Application Publication No. 2006-160575 discloses that supplying moisture vapor as the reactive gas is effective in the presence of a molten salt. The inventors of the present invention have found that the technique of the present invention achieves sufficiently more favorable effects in eliminating boron than this known technique. In the embodiment of the present invention, the blending ratio between the molten salt and the silicon metal preferably falls within the range from 2 to 90 parts by weight of the molten salt, more preferably, 5 to 40 parts by weight of the molten salt, with respect to 100 parts by weight of silicon.

After this, an inert gas is blown into the silicon melt (a step S180). The purification furnace is provided with a nozzle for circulating the reactive gas, and one end of the nozzle is put into the silicon melt containing both the molten silicon metal and the molten salt. Here, the circulation of the inert gas through the nozzle is started in advance. In this manner, the inert gas becomes gas bubbles in the silicon melt, so that the silicon melt is bubbled. This bubbling gas stirs the silicon melt and helps blend the silicon and molten salt smoothly.

Subsequently, the reactive gas is supplied to the nozzle (a step S200), to be blown into the silicon melt. The reactive gas contains a chlorine-atom containing gas, or a gas mixture of a chlorine-atom containing gas and a moisture vapor gas. The supply amount of the reactive gas is specified. The reactive gas advances the refinement reaction. Here, an inert gas, for example, an argon gas, may be preferably added to the reactive gas, so that necessary bubbling or stirring is created in the silicon metal. The supply amount of the reactive gas can be freely selected, but preferably falls within the range of 0.3 to 3 NL/min, in the room-temperature volume, for 0.6 Kg of the silicon metal, more preferably, 0.5 to 2.0 NL/min.

Examples of the chlorine-atom containing gas include an inorganic gas that does not contain carbon, such as a chlorine gas, a hydrogen chloride gas or silicon tetrachloride, and an organic gas containing carbon, such as CH₂Cl₂ or CCl₄. The organic gas generates solid substances such as free carbon when decomposes. If the generated solid substances mix with the molten silicon, the semiconductor characteristics of the silicon may be impaired, such as a shortened lifetime. Therefore, it is preferable to use a chlorine-atom containing inorganic gas. More particularly, a chlorine gas and a hydrogen chloride gas are preferred due to their high responsiveness, and a chlorine gas is more preferable. Silicon tetrachloride is also preferable for the following reasons. Silicon tetrachloride is a liquid under the standard state, but is a gas at the melting temperature of silicon. Therefore, under the supply conditions defined in the embodiment of the present invention, silicon tetrachloride effectively eliminates boron by contacting the molten silicon.

Much care needs to be taken to handle the chlorine-atom containing gas since the gas itself is usually toxic. To supply a hydrogen chloride gas or a chlorine gas, a gas cylinder is normally used because of its advantages relating to flow rate control and gas leakage prevention, and can be also favorably used in the method relating to the embodiment of the present invention. SiCl₄ is guided to the purification furnace in such a manner that the liquid is kept in a liquid tank and heated to be evaporated, or in such a manner that a carrier gas is bubbled in silicon tetrachloride to accompany silicon tetrachloride.

On the other hand, the moisture vapor can be supplied to the silicon melt from a moisture vapor boiler, or in the form of a gas mixture containing moisture vapor and a carrier gas by supplying the carrier gas to warm water in a container. The gas mixture containing moisture vapor and chlorine does not chemically change at the room temperature, but is corrosive. Therefore, attention needs to be paid for the material of a gas supply pipe. The blending ratio between the carrier gas (the inert gas) and the chlorine-atom-containing gas in the gas mixture preferably falls in the range from 19:1 to 5:5, more preferably, 9:1 to 6:4. When moisture vapor is also used, the blending ratio between the carrier gas and the mixture of the chlorine-atom-containing gas and moisture vapor falls within the range from 19:1 to 5:5.

In the above manner, the reactive gas is supplied to the silicon melt in a specified amount for a specified duration, and the purification reaction is then stopped (a step S220). Note that the silicon melt includes both the molten silicon metal and the molten salt, as described above. The reactive gas may be supplied to the silicon melt by using the nozzle as mentioned above, but alternatively by means of an inlet provided at the side or bottom surface of the crucible. The purifying method relating to the embodiment of the present invention can reduce the boron concentration of 10 to 50 ppm in pre-purified silicon metal to no more than 4 ppm, preferably, 0.1 to 0.3 ppm.

The reactive gas used in the embodiment of the present invention is preferably a chlorine gas or a gas mixture containing a chlorine gas and moisture vapor, more preferably a chlorine gas. In either case, the reactive gas preferably does not contain oxygen. In the embodiment of the present invention, silicon tetrachloride and a mixture of silicon tetrachloride and moisture vapor can also be preferably used. During the purification relating to the embodiment of the present invention, the temperature of the silicon melt is preferably made as high as possible within the capability of processing equipment, since the boron elimination improves as the temperature ofthe silicon melt rises.

Subsequently, the purified silicon metal is separated from the molten salt (a step S240). The silicon metal may be separated from the molten salt in the silicon melt or after solidification of the silicon melt.

The molten silicon, which has been purified by the reactive gas, reaches a temperature equal to or lower than the melting point by cooling of the furnace, and thus solidifies. Here, because of solidification segregation of the silicon and the impurity elements, the impurity concentration is uneven in the solidified silicon. Therefore, in order to analyze the silicon that has been subjected to the purifying method relating to the embodiment of the present invention for the purpose of confirming the technical effects of the embodiment of the present invention, a plurality of samples may be extracted from different positions of the ingot to determine a representative concentration, or samples may be extracted directly from the molten silicon, taking impurity segregation into consideration.

The purifying method relating to the embodiment of the present invention can effectively eliminate boron from silicon metal at a higher rate than conventional known purifying methods, and reduce the average boron content to no more than 4 ppm. The embodiment of the present invention can reduce the residual boron concentration to 0.1 to 0.3 ppm, which is favorable for solar-cell silicon, by optimizing conditions including the amount of the molten salt used, the composition ratio of the molten salt, the type of the reactive gas, and the supply duration of the reactive gas. The optimal conditions can be determined depending on technical requirements such as the desired boron concentration, the processing cost, the available equipment. Silicon having intermediate purity (approximately 6N) obtained by the purifying method relating to the embodiment of the preset invention can be used to manufacture solar cell panels.

Note that the residual boron concentration of no more than 1 ppm does not necessarily need to be achieved by the above-described purifying method relating to the embodiment of the present invention alone. Alternatively, considering the limitations imposed by the manufacturing cost and purification time period, the purifying method relating to the embodiment of the present invention may be used to lower the boron concentration to a predetermined boron concentration, for example, 4 or 3 ppm, and a known method, such as plasma melting under a predetermined atmosphere, may be then used to further lower the boron concentration to no more than 1 ppm, desirably 0.1 to 0.3 ppm.

### <Purifying Apparatus>

No particular limitations are put on a purifying apparatus for use with the purifying method relating to the embodiment of the present invention. A conventionally known purifying apparatus can be employed.

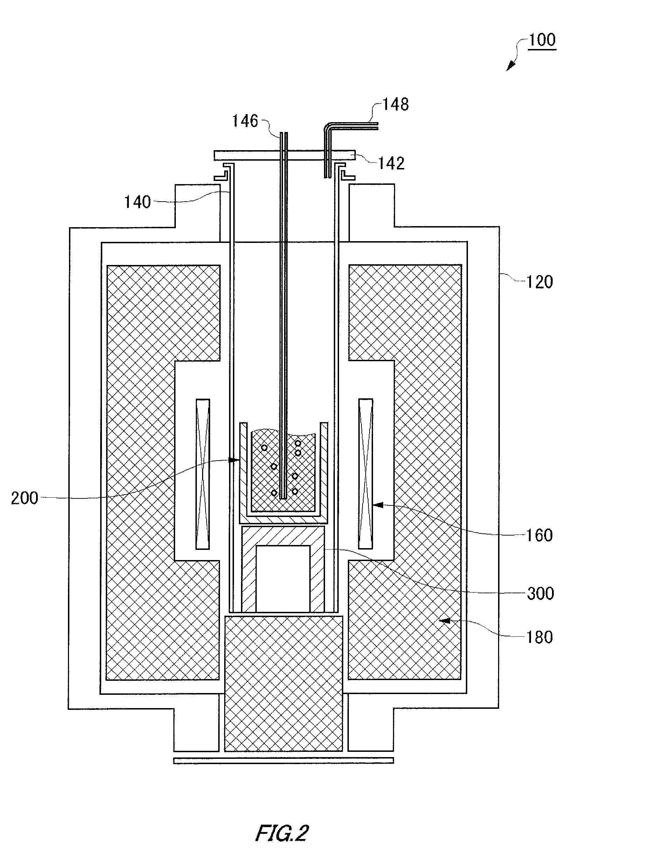

Fig. 2 is a schematic view illustrating an exemplary purifying apparatus 100 for use with a purifying method relating to an embodiment of the present invention. The purifying apparatus 100 includes a chamber 120, a core tube 140, a heat generator 160, and a heat insulator 180. The core tube 140 is arranged within the chamber 120, and the heat generator 160 is arranged so as to surround the core tube 140. The heat insulator 180 is disposed in a space between the chamber 120 and a center portion in which the core tube 140 and the heat generator 160 are provided.

The core tube 140 is closed at one end, and has a flange 142 at the other end. The flange 142 has a gas outlet tube made of silica glass, so as to be configured to let a gas out from the core tube 140 and let a gas into the core tube 140. The core tube 140 is put into a furnace with its closed end being positioned lower. The closed end of the lower portion of the core tube 140 is positioned so as to be lower than the central portion of the furnace, such that the bottom of the core tube 140 shows a lower temperature than the hottest portion of the furnace when the temperature of the furnace is raised. Inside the core tube 140, a stage 300 made of graphite and a crucible 200 having therein a mixture of silicon metal and a molten salt are disposed. Inside the core tube 140, the crucible 200 is positioned at substantially the same height as the heat generator 160. Here, the size of the stage 300 is preferably set such that the crucible 200 is positioned in the hottest portion ofthe furnace.

Through the gas outlet tube, a bubbling nozzle 146 is inserted into the crucible 200. In addition to the bubbling nozzle 146, a gas outlet nozzle 148 is provided in the gas outlet tube.

The following describes the present invention based on some embodiments. The present invention, however, is not limited to such.

### (First and Second Embodiments and First and Second Reference Examples)

### <Preparation of Composite Molten salt>

SiO₂ powders and CaO powders were sufficiently blended with a ratio of 3:2 by weight, placed in the crucible 200 made of graphite having inside dimensions of 200×80ϕ with the ratio of 3:2 by weight being maintained, and melted by increasing the temperature to 1,500 °C. The melt was then cooled down, and the result is then adjusted to have an appropriate size by using a diamond cutter.

### <Purification>

Silicon metal of 600 g and the above-descnbed composite molten salt of 400 g were placed in the crucible 200 made of graphite having inside dimensions of 200×80ϕ.

The bubbling nozzle 146 made of alumina and having a size of 10ϕ was inserted into the core tube 140 through the gas outlet tube, so that an end of the bubbling nozzle 146 is positioned in the crucible 200. Through the bubbling nozzle 146, an argon gas was supplied to substitute the gas within the core tube 140 made of silica glass with the inert argon gas. After this, the furnace was heated to the temperature of 1,540 °C at the rate of 500 °C/Hr. As a result of this temperature increase, the silicon metal and molten salt melted, to produce a silicon melt. Subsequently, the end of the bubbling nozzle 146 was immersed within the silicon melt, and it could be observed through the silica glass tube that the argon gas flowing through the bubbling nozzle 146 was bubbled in the silicon melt.

Following this, a reactive gas was supplied through the bubbling nozzle 146. The reactive gas contains a chlorine gas and a moisture vapor gas, and is attenuated by the argon gas. After two hours of bubbling, the supply of the reactive gas was stopped. Then, the bubbling nozzle 146 was removed from the silicon melt, and the temperature of the furnace was lowered such that the silicon melt solidified. Here, since the silicon metal expands in volume as a result of the solidification, too fast solidification would significantly damage the crucible 200. Considering this, the temperature fall rate was set at 100 °C/hr until 1,200 °C. After this, electric supply was stopped and the furnace was left to naturally cool down. After the cooling, some cracks were found in the crucible 200, but no silicon leakage was found. Each portion of the resulting silicon was sampled and analyzed by ICP-AES. The result of the analysis is shown in Table 1.

**Table 1**

| | Processing Duration | Total Gas Flow Rate | Composition of Gas [NL/min] | | | Average Boron Concentration |
|---|---|---|---|---|---|---|
| | | | Ar | Cl₂ | H₂O | ppm |
| First Reference Example | 2 Hours | 1.0 NL/min | 1 | 0 | 0 | 11 |
| Second Reference Example | 2 Hours | 1.0 NL/min | 0.7 | 0 | 0.3 | 5.7 |
| First Embodiment | 2 Hours | 1.0 NL/min | 0.87 | 0.13 | 0 | 3.6 |
| Second Embodiment | 2 Hours | 1.0 NL/min | 0.57 | 0.13 | 0.3 | 1.9 |

As seen from Table 1, the effectiveness of the boron elimination clearly differed depending on the types ofthe reactive gas.

### (Fifth and Sixth Embodiments)

Silicon metal was processed by using the same molten salt and the same method as in the first embodiment. Referring to the reactive gas, silicon tetrachloride was used in place of chlorine.

**Table 2**

| Embodiment | Processing Duration | Total Gas Flow Rate | Composition of Gas [NL/min] | | | Average Boron Concentration |
|---|---|---|---|---|---|---|
| | | | Ar | SiCl₄ | H₂O | ppm |
| Fifth Embodiment | 2 Hours | 0.95 NL/min | 0.87 | 0.06 | 0 | 4.3 |
| Sixth Embodiment | 2 Hours | 0.95 NL/min | 0.64 | 0.06 | 0.3 | 2.6 |

As seen from Table 2, the boron concentration could be effectively reduced by using silicon tetrachloride in the reactive gas.

### (Seventh and Eighth Embodiments and Third and Fourth Reference Examples)

The composite molten salt used in the first embodiment and CaF₂ were put in the crucible 200 made of graphite with the ratio of 9:1, melted at the temperature of 1,500 °C, then cooled down, and cut into an appropriate size by using a diamond cutter. The resulting composite molten salt of 400 g and silicon metal of 600 g were put in the crucible 200, which is made of graphite and has inside dimensions of 200L×80ϕ, and processed in the same manner as in the first embodiment. In the middle of the melting step, the bubbling nozzle 146 was used to stir the silicon melt, and the viscosity of the silicon melt was checked based on the stirring resistance. The viscosity of the silicon melt was obviously lower than the silicon melt in the first embodiment.

**Table 3**

| | Processing Duration | Total Gas Flow Rate | Composition of Gas [NL/min] | | | Average Boron Concentration |
|---|---|---|---|---|---|---|
| | | | Ar | Cl₂ | H₂O | ppm |
| Third Reference Example | 2 Hours | 1.0 NL/min | 1 | 0 | 0 | 11 |
| Fourth Reference Example | 2 Hours | 1.0 NL/min | 0.7 | 0 | 0.3 | 5 |
| Seventh Embodiment | 2 Hours | 1.0 NL/min | 0.87 | 0.13 | 0 | 4 |
| Eighth Embodiment | 2 Hours | 1.0 NL/min | 0.57 | 0.13 | 0.3 | 2.1 |

### (First to Fourth Comparative Examples)

Silicon metal was processed by using the same method as in the first embodiment, except that the molten salt was not used, with the use ofthe reactive gas shown in Table 2,

**Table 4**

| Comparative Example | Processing Duration | Total Gas Flow Rate | Composition of Gas [NL/min] | | | Average Boron Concentration |
|---|---|---|---|---|---|---|
| | | | Ar | Cl₂ | H₂O | ppm |
| First Comparative Example | 2 Hours | 1.0 NL/min | 1 | 0 | 0 | 13 |
| Second Comparative Example | 2 Hours | 1.0 NL/min | 0.7 | 0 | 0.3 | 11 |
| Third Comparative Example | 2 Hours | 1.0 NL/min | 0.87 | 0.13 | 0 | 13 |
| Fourth Comparative Example | 2 Hours | 1.0 NL/min | 0.57 | 0.13 | 0.3 | 12 |

As seen from Table 4, the processing with the use of the reactive gas could scarcely eliminate boron without the molten salt.

While the embodiments of the present invention have been described, the technical scope of the invention is not limited to the above described embodiments. It is apparent to persons skilled in the art that various alterations and miprovements can be added to the above-described embodiments. It is also apparent from the scope of the claims that the embodiments added with such alternations or improvements can be included in the technical scope ofthe invention.

A silicon purifying method relating to an embodiment of the present invention can eliminate boron contained within silicon at a lower cost and more efficiently than any known silicon purifying methods.

## Claims

1. A silicon purifying method comprising:
preparing a mixture containing both silicon in a molten state and a molten salt;
introducing a gas containing a chlorine atom into the mixture; and
introducing moisture vapor together with the chlorine-atom containing gas.

2. The silicon purifying method as set forth in Claim 1, wherein the chlorine-atom containing gas is a chlorine gas.

3. The silicon purifying method as set forth in Claim 1, wherein the chlorine-atom containing gas is silicon tetrachloride.

4. The silicon purifying method as set forth in Claim 1, wherein the molten salt contains at least a mixture of silicon dioxide and calcium oxide.

5. The silicon purifying method as set forth in Claim 4, wherein a weight ratio ofthe silicon dioxide in the molten salt is 35 to 75 weight%.

6. The silicon purifying method as set forth in Claim 1, wherein the molten salt contains calcium fluoride.

7. The silicon purifying method as set forth in Claim 6, wherein a weight ratio ofthe calcium fluoride in the molten salt is 1 to 20 weight%.

8. The silicon purifying method as set forth in Claim 1, further comprising
putting the molten salt into the silicon in the molten state during the preparation of the mixture.

9. The silicon purifying method as set forth in Claim 1, wherein
the preparation of the mixture includes heating and melting silicon by using an induction-heating electric furnace.

10. The silicon purifying method as set forth in Claim 1, further comprising
eliminating a metal element based on solidification segregation.

11. The silicon purifying method as set forth in Claim 1, further comprising
separating the silicon from the mixture containing both the silicon in the molten state and the molten salt after the silicon is purified.

12. The silicon purifying method as set forth in Claim 1, wherein
the preparation of the mixture further includes washing the silicon with an acid before the silicon turns into the molten state.

13. The silicon purifying method as set forth in Claim 1, wherein
a ratio ofthe chlorine-atom containing gas and the moisture vapor is substantially 1:3.

14. Silicon manufactured by using the silicon purifying method as set forth in one of Claims 1 to 13, wherein a boron concentration is equal to or less than 4 ppm

15. The silicon as set forth in Claim 14, wherein
the boron concentration is equal to or less than 1 ppm.

16. The silicon as set forth in Claim 15, wherein
the boron concentration falls in a range from 0.1 ppm to 0.3 ppm.

17. A solar cell manufactured by using, as a raw material, silicon manufactured by using the silicon purifying method as set forth in one of Claims 1 to 13.
